# FASCICULE DE BREVET EUROPEEN

(11) **EP 1 442 480 B1**
(45) Date de publication et mention de la délivrance du brevet: **06.03.2019**
(21) Numéro de dépôt: 02785549.3
(22) Date de dépôt: 15.10.2002
(51) Int. Cl.: B81B 7/00, H01L 23/10, H01L 23/31, H01L 23/34, H01L 31/0203, H01L 31/024, G02B 6/42

(54) **DISPOSITIF D'ENCAPSULATION HERMETIQUE DE COMPOSANT DEVANT ETRE PROTEGE DE TOUTE CONTRAINTE**
HERMETISCHE VERKAPSELUNGSVORRICHTUNG EINES BAUELEMENTES, DAS VOR JEGLICHEN VERSPANNUNGEN GESCHÜTZT WERDEN MUSS
DEVICE FOR THE HERMETIC ENCAPSULATION OF A COMPONENT THAT MUST BE PROTECTED AGAINST ALL STRESSES

(30) Priorité: 09.11.2001 FR 0114543
(43) Date de publication de la demande: 04.08.2004
(73) Titulaire: 3D Plus, 78530 Buc (FR)
(72) Inventeur: VAL, Christian, Thales Int. Prop., F-94117 Arcueil Cedex (FR)
(74) Mandataire: Henriot, Marie-Pierre
(86) Numéro de dépôt international: PCT/FR2002/003524
(87) Numéro de publication internationale: WO 2003/041163

(56) Documents cités:
- EP-A- 0 348 361
- US-A- 5 524 339
- US-A- 5 793 104
- US-B1- 6 177 726
- PATENT ABSTRACTS OF JAPAN vol. 010, no. 209 (E-421), 22 juillet 1986 (1986-07-22) -& JP 61 048944 A (MATSUSHITA ELECTRONICS CORP), 10 mars 1986 (1986-03-10)
- PATENT ABSTRACTS OF JAPAN vol. 015, no. 479 (E-1141), 5 décembre 1991 (1991-12-05) -& JP 03 206691 A (NEC CORP), 10 septembre 1991 (1991-09-10)

## Description

L'invention se rapporte à un dispositif d'encapsulation hermétique de composant devant être protégé de toute contrainte, du type comprenant un boîtier formé de deux parties assemblées pour délimiter un volume intérieur où est disposé le composant dans une atmosphère sèche.

Dans un certain nombre d'applications, on est confronté à des problèmes de composants très fragiles, ne pouvant supporter aucune contrainte mécanique ou thermique et devant être protégé absolument contre l'humidité et/ou l'oxydation.

Ces problèmes se posent notamment pour les composants optiques ou optoélectroniques où l'humidité vient perturber ou dégrader les performances du composant et ses couplages optiques d'entrée et de sortie, notamment avec des fibres optiques. De plus, toute contrainte vient modifier ces couplages et induire des pertes inacceptables. Enfin, de tels composants doivent être régulés très précisément en température, d'où des sorties de conducteurs électriques et une électronique associée importante.

On retrouve également ces problèmes pour les Systèmes Micro-Electro-Mécaniques (MEMS : en anglais Micro-Electro-Mechanical Systems). Ces composants résultent de l'intégration d'éléments mécaniques, capteurs, actuateurs et électroniques sur un substrat silicium commun grâce à l'utilisation de technologies de microfabrication. Ils sont extrêmement sensibles à l'humidité qui vient coller tout élément mobile et aux contraintes, même de peu d'ampleur, qui viennent détruire les calibrations effectuées en laboratoire ou usine (par exemple dans le cas de capteurs notamment spatiaux).

Pour remédier à ces problèmes, on pourrait penser à une protection par moulage ou enrobage plastique. Mais cette solution est complètement exclue, non seulement pour les MEMS (parties mobiles à laisser libres) mais également pour tous les composants qui ne peuvent supporter les contraintes et/ou échauffements liés à cette technologie.

Une solution envisageable est donc la mise en boîtier. Pour cela, on place le composant à l'intérieur d'un volume délimité par des parties creuses, au moins pour l'une d'entre elles, assemblées, le volume intérieur contenant une atmosphère sèche (azote, air sec...). Le problème majeur est l'herméticité, d'une part, au niveau de la constitution des parties du boîtier elles-mêmes et, d'autre part, au niveau de leur assemblage et du passage des connexions, optiques et/ou électriques avec l'extérieur. En ce qui concerne le boîtier, on peut utiliser des parties métalliques mais cela est plus coûteux qu'un boîtier plastique. En ce qui concerne l'assemblage et le passage des connexions, l'utilisation simplement de colles ne peut être envisagée car celles-ci ne peuvent pas constituer un scellement hermétique.

On est donc conduit là aussi à des solutions coûteuses de brasage. En particulier, pour assurer l'étanchéité du passage de fibres optiques, il faut baser les fibres de verre ce qui est délicat et très coûteux.

Dans JP-S61-48944 le boîtier est protégé par une couche en résine époxy. Dans EP 0 348 361 A2 le boîtier est protégé par une couche en plastique. Dans US 6,177,726 B1 la connexion sortant du dispositif est encapsulé dans une couche de SiO₂.

L'invention a pour objet de remédier à ces inconvénients en utilisant des matériaux et structures simples et peu coûteux, tout en assurant une herméticité d'excellente qualité.

Selon un premier aspect de l'invention selon la revendication 1, il est donc prévu un dispositif d'encapsulation hermétique de composant devant être protégé de toute contrainte, du type comprenant un boîtier formé d'au moins deux parties assemblées pour délimiter un volume intérieur où est disposé le composant dans une atmosphère sèche, ledit dispositif étant caractérisé en ce que les deux parties du boîtier sont assemblées par collage, entre elles ou par l'intermédiaire d'un substrat supportant ledit composant, et en ce que l'ensemble du boîtier est protégé par une couche de protection minérale qui s'étend également sur une longueur minimum prédéterminée sur les connexions et/ou liaisons sortant du boîtier.

Ainsi, quelle que soit la nature du matériau du boîtier (plastique, céramique ou métallique), l'herméticité est assurée par la couche minérale. D'autre part, au niveau du passage des liaisons ou connexions où l'humidité pourrait pénétrer, en particulier le long des gaines plastiques de ces connexions/liaisons, l'herméticité est assurée en augmentant d'une longueur minimum le trajet à parcourir pour parvenir à l'intérieur du boîtier. Cette longueur minimum est de préférence de l'ordre de quelques millimètres.

Selon l'invention, le dispositif est caractérisé en ce que ladite couche de protection est une couche de SiOₓ avec x sensiblement compris entre 1,4 et 2.

On part d'une valeur de x inférieure à 2 au contact du boîtier de manière à assurer une adhérence optimale et atteindre la valeur 2 à l'extérieur pour une herméticité maximum, le matériau SiO₂ étant très dur et hermétique.

Selon un mode de réalisation de l'invention adapté aux MEMS, il est prévu un dispositif du type ci-dessus caractérisé en ce que ledit composant est un MEMS, monté sur un substrat portant des conducteurs de connexion, en ce que ledit boîtier est formé de deux parties disposées en vis-à-vis de part et d'autre du substrat et collées sur celui-ci, ladite couche de protection s'étendant sur lesdites deux parties et sur lesdits conducteurs et le substrat sur ladite longueur minimum.

Selon un autre mode de réalisation de l'invention adapté aux composants optiques ou optoélectroniques, il est prévu un dispositif caractérisé en ce que ledit composant est un composant optique ou optoélectronique fixé sur une première face d'un substrat plan, en ce que l'autre face dudit substrat porte en vis-à-vis du composant un élément de réglage de température, alimenté par un circuit électronique de régulation de température, et en ce que une première partie dudit boîtier comporte au moins une protubérance intérieure pour servir de support audit substrat.

En outre, si le circuit électronique de régulation de température est réalisé sous forme d'un bloc à interconnexions en trois dimensions, celui-ci peut-être fixé par collage sur une des parties du boîtier et englobé dans la couche de protection de l'ensemble, ou bien également constituer en lui-même une des parties du boîtier pour être assemblé par collage avec l'autre partie.

L'invention sera mieux comprise et d'autres caractéristiques et avantages apparaîtront à l'aide de la description ci-après et des dessins joints ou :
- la figure 1 représente un mode de réalisation du dispositif d'encapsulation selon l'invention, adapté à un MEMS ;
- la figure 2 est un schéma de principe d'un composant optoélectronique ;
- la figure 3 est la représentation en coupe d'un autre mode de réalisation du dispositif selon l'invention ;
- la figure 4 montre une variante du dispositif de la figure 3 où une partie du boîtier est constitué par un bloc à interconnexions en trois dimensions ;
- la figure 5 est un autre mode de réalisation où le support du composant est assuré par ledit bloc ; et
- la figure 6 est une variante du dispositif de la figure 5.

Comme on l'a déjà expliqué ci-dessus le principe de base de l'invention est d'utiliser un boîtier en au moins deux parties assemblées par collage et d'assurer l'herméticité par une couche de protection minérale, s'étendant sur le boîtier et sur une longueur minimum des connexions.

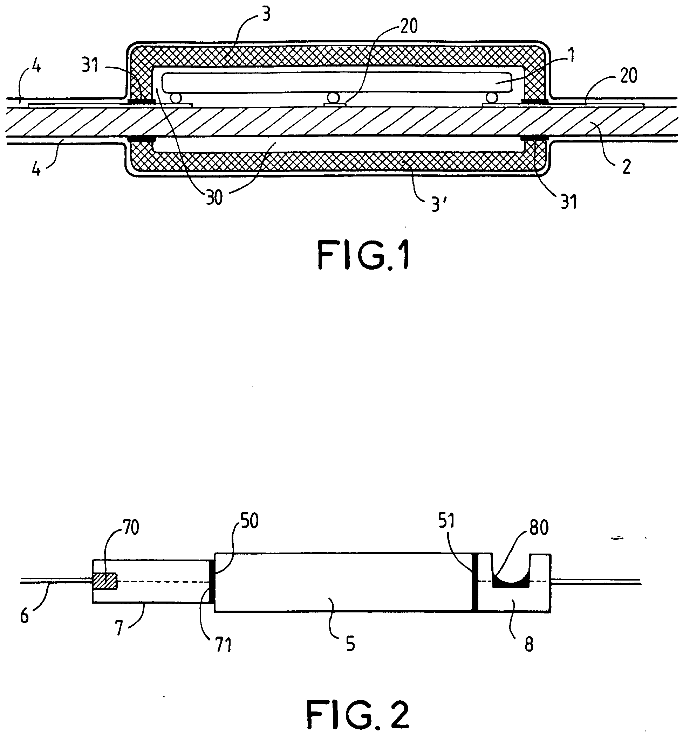

La figure 1 représente un premier mode de réalisation de l'invention, adapté à un MEMS. Ce composant 1 est monté sur un substrat 2 portant des conducteurs 20 de connexion. Le composant 1 et la partie de substrat en regard sont enfermés dans un volume délimité par un boîtier en deux parties 3, 3' constituant des cavités 30, disposées en vis-à-vis de part et d'autre du substrat et collées sur celui-ci par une colle 31 adéquate. Les parties 3, 3' du boîtier peuvent être en tout matériau classique pour cette utilisation (plastique, céramique, métallique...). Le volume intérieur aux cavités est rempli d'une atmosphère sèche (azote, air sec...). L'herméticité de l'ensemble est assurée, selon l'invention, par une couche de protection minérale 4 s'étendant sur les deux parties 3, 3' et sur le substrat 2 et les conducteurs 20 sur une longueur minimum prédéterminée pour éviter toute pénétration de l'humidité ou autre polluant, comme on le décrira à nouveau ultérieurement.

La couche 4 est composée d'un oxyde de silicium.Le matériau choisi présente une bonne adhérence aux parties à recouvrir et les qualités d'herméticité et de résistance requises.

On utilise une couche d'oxyde de silicium Si Oₓ, où l'indice x varie entre 1,4 et 2. Ce matériau passe d'un état plastique mou pour x de l'ordre de 1,4 à un état très dur pour x=2.

Le dépôt d'une telle couche peut s'effectuer par dépôt chimique assisté par plasma (PECVD : en anglais Plasma Excited Chemical Vapor Déposition). On part d'une valeur de x inférieure à 2 au contact du boîtier, pour assurer une adhérence optimale, jusqu'à la valeur 2 à l'extérieur pour assurer une herméticité et une résistance maximum.

De préférence, on choisira pour la couche de protection une épaisseur comprise entre 0,1 et 5 micromètres. Une valeur préférée est de l'ordre de 0,5 micromètre.

La figure 2 est un schéma de principe d'un composant optoélectronique inséré sur une liaison par fibre optique. Le composant 5 comprend des faces d'entrée et de sortie 50, 51 qui sont couplées à des fibres 6, gainées ou non de polymère, maintenues et terminées sur des ferrules 7 ou bloc de verre en V 8. Les liaisons et maintiens sont assurés par différents collages 70, 71, 80 qui ne sont pas hermétiques et permettent donc la dégradation des qualités optiques et des couplages en laissant passer l'humidité. Le corps du composant 5 doit également être protégé contre l'humidité (ou l'oxydation éventuellement).

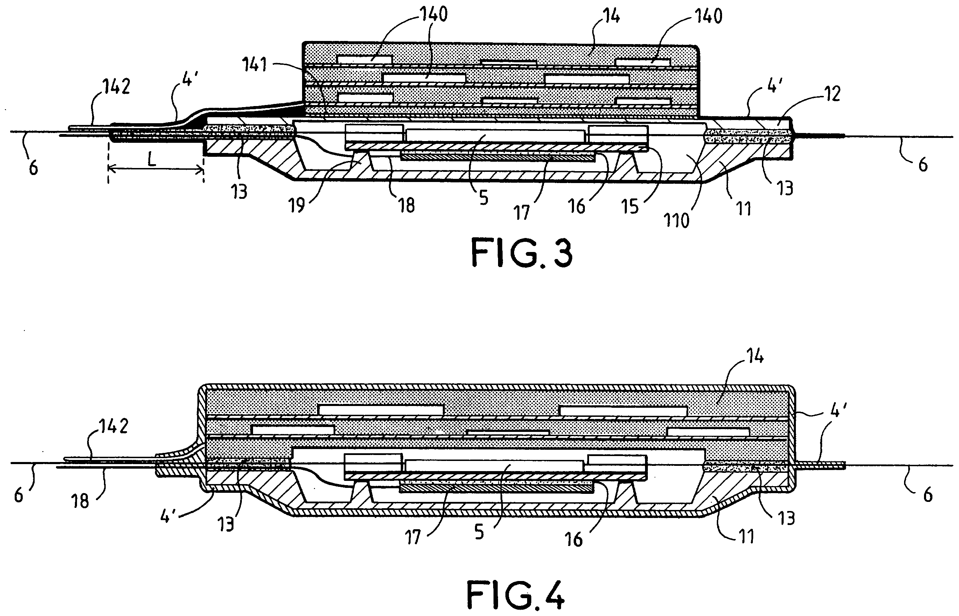

La figure 3 représente, en coupe, un premier mode de réalisation du dispositif d'encapsulation selon l'invention pour un composant de ce type. Sur la figure 3, le composant 5 est monté sur un substrat 15 par collage par exemple sur une face du substrat plan. L'autre face du substrat porte, fixé par collage 16, un élément thermique de chauffage ou de refroidissement 17 pour le réglage de la température. Ce réglage doit en général être très précis et nécessite donc un circuit électronique de régulation de température d'encombrement non négligeable. L'ensemble composant 5 - substrat 15 - élément thermique 17 est disposé dans le volume intérieur d'un boîtier composé par exemple de deux parties 11, 12 assemblées par collage 13. L'ensemble 5, 15, 17 est supporté par exemple par au moins une protubérance 19 intérieure dans la partie 11 du boîtier. Le substrat 15 peut être collé sur ces protubérances pour assurer le maintien mécanique tout en maintenant une bonne isolation thermique vis-à-vis de l'extérieur grâce à l'atmosphère sèche existant à l'intérieur du volume 110.

Comme on l'a expliqué ci-dessus, le composant 5 et l'élément thermique 17 sont habituellement associés à un circuit électronique assurant en particulier la régulation de température. Pour limiter l'encombrement de cette électronique, il est prévu de la réaliser sous forme d'un bloc à interconnexions en trois dimensions 14. La réalisation d'un tel bloc est connue en soi et on peut par exemple en trouver une description dans le brevet français N° 2 688 630. On obtient ainsi un circuit réalisé sous forme de bloc très compact incorporant des composants électroniques 140. Ce bloc 14 est fixé à une partie 12 du boîtier, par exemple par collage 141.

Il est clair que le boîtier 11, 12 doit laisser le passage pour les fibres 6 et les conducteurs électriques 18 alimentant l'élément thermique de réglage 17. D'autre part, les connexions du bloc 14 s'effectuent vers l'extérieur en général par câble plat 142. Selon l'invention, on assure l'herméticité en déposant une couche de protection minérale 4', comme déjà décrit en relation avec la figure 1, qui enrobe l'ensemble boîtier 11, 12 et bloc en trois dimensions 14. De plus, on prévoit que cette couche de protection doit s'étendre sur les liaisons par fibre optique 6 et les connexions électriques 18, 142 vers l'extérieur sur une longueur minimum prédéterminée L. En effet, comme on l'a mentionné, les collages et les gainages plastiques ont une certaine perméabilité longitudinale qui diminue naturellement avec la longueur du trajet à franchir par l'élément polluant. En imposant un supplément de trajet L, on maximise l'herméticité au niveau de ces passages.

De préférence la longueur L est de l'ordre de quelques millimètres.

Une solution réduisant la longueur minimum pourrait consister à dénuder partiellement les liaisons et connexions électriques à la sortie du boîtier sur une faible longueur (moins de 1 millimètre par exemple) et à arrêter la couche minérale sur ces parties dénudées. En effet, le contact couche minérale/verre des fibres ou couche minérale/métal des conducteurs assure une parfaite herméticité de ces sorties.

Une variante du dispositif de la figure 3 est représentée sur la figure 4.

Selon cette variante, la partie 12 du boîtier de la figure 3 est remplacée par le bloc 14 lui-même, qui est fixé par collage 13 à la première partie 11 du boîtier pour délimiter le volume intérieur où est disposé le composant 5. Les mêmes numéros de référence renvoient aux mêmes éléments que sur la figure 3. Cette variante a l'avantage de supprimer une des parties du boîtier.

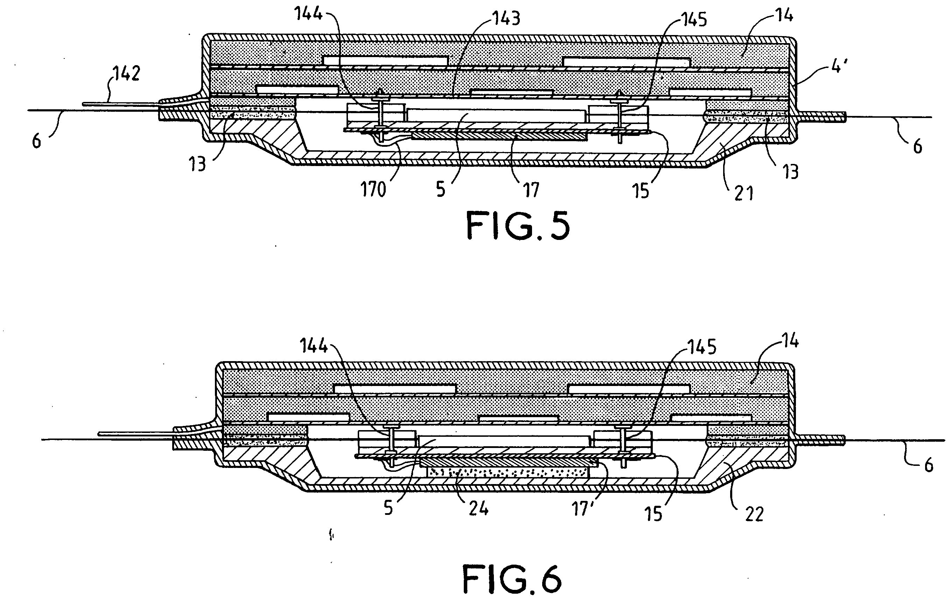

La figure 5 représente un autre mode de réalisation dérivé de celui de la figure 4. Dans ce mode de réalisation, le bloc 14 comporte vers l'intérieur du boîtier des broches de connexion conductrices 144, 145 sensiblement perpendiculaires à la face intérieur 143 du bloc. Sur ces broches est fixé mécaniquement le substrat 15 portant le composant 5 et l'élément de réglage de température 17. Il n'y a ainsi plus besoin des protubérances 19. De plus, ces broches assurent la liaison électrique entre l'élément 17 et le circuit électronique 14. Les fils d'alimentation 170 de l'élément 17 sont reliés, par soudure et/ou par le biais de pistes conductrices sur le substrat, à ces broches.

Un avantage de cette réalisation est que les fils d'alimentation de l'élément thermique 17 n'ont plus besoin de passer à travers le boîtier vers l'extérieur, d'où réduction du nombre de zones où l'herméticité doit être renforcée.

La figure 6 montre une variante de la figure 5, les mêmes numéros de référence renvoyant aux mêmes éléments sur toutes les figures. Dans cette variante, on utilise comme élément thermique de réglage de température un élément de refroidissement à effet Peltier 17' fixé, comme précédemment, par collage au substrat 15, la face froide de cet élément 17' étant tournée vers le substrat et le composant. Pour assurer une bonne évacuation thermique vers l'extérieur de l'énergie thermique développée sur la face chaude de l'élément 17', on prévoit que la partie de boîtier 22 est en matériau bon conducteur thermique, par exemple métallique, et une couche de liaison 24 est disposée entre ladite face chaude et la face intérieure de la partie de boîtier 22 pour assurer la liaison thermique entre l'élément thermique 17' et le boîtier 22.

Bien entendu, les exemples de réalisation décrits ne sont nullement limitatifs de l'invention, en particulier, tout composant ayant des exigences similaires quant à la protection contre l'environnement et les contraintes peut être encapsulé selon les principes de l'invention. L'invention est limitée par les revendications.

## Revendications

1. Dispositif d'encapsulation hermétique de composant devant être protégé de toute contrainte, du type comprenant un boîtier formé d'au moins deux parties assemblées pour délimiter un volume intérieur où est disposé le composant dans une atmosphère sèche, ledit dispositif étant **caractérisé en ce que** les deux parties (3, 3' ; 11, 12 ;11', 14 ; 21, 14 ; 22, 14) du boîtier sont assemblées par collage, entre elles ou par l'intermédiaire d'un substrat supportant ledit composant, **en ce que** l'ensemble du boîtier est protégé par une couche de protection minérale (4, 4') de SiOx avec x sensiblement compris entre 1,4 et 2 qui s'étend également sur une longueur minimum prédéterminée sur les connexions et/ou liaisons sortant du boîtier, et **en ce que** la valeur de x varie d'une première valeur inférieure à 2 au contact du boîtier, déterminée pour assurer une adhérence optimale, jusqu'à la valeur 2 à l'extérieur pour assurer une herméticité maximum.

2. Dispositif selon la revendication 1, **caractérisé en ce que** ladite longueur (L) minimum prédéterminée est de l'ordre de quelques millimètres.

3. Dispositif selon l'une des revendications 1 ou 2, **caractérisé en ce que** l'épaisseur de ladite couche de protection est sensiblement comprise entre 0,1 et 5 micromètres.

4. Dispositif selon la revendication 3, **caractérisé en ce que** ladite épaisseur est de l'ordre de 0,5 micromètre.

5. Dispositif selon l'une quelconques des revendications 1 à 4, **caractérisé en ce que** ledit composant est un MEMS (1), monté sur un substrat (2) portant des conducteurs (20) de connexion, **en ce que** ledit boîtier est formé de deux parties (3,3') disposées en vis-à-vis de part et d'autre du substrat et collées (31) sur celui-ci, ladite couche de protection (4) s'étendant sur lesdites deux parties et sur lesdits conducteurs (20) et le substrat sur ladite longueur minimum.

6. Dispositif selon l'une quelconque des revendications 1 à 4, **caractérisé en ce que** ledit composant est un composant optique ou optoélectrique (5) fixé sur une première face d'un substrat (15) plan, **en ce que** l'autre face dudit substrat porte en vis-à-vis du composant un élément de réglage de température (17), alimenté par un circuit électronique de régulation de température (14), et **en ce que** une première partie (11) dudit boîtier comporte au moins une protubérance intérieure (19) pour servir de support audit substrat (15).

7. Dispositif selon la revendication 6, **caractérisé en ce que** ledit circuit de régulation de température est réalisé sous forme d'un bloc à interconnexions en trois dimensions (14) fixé sur l'autre partie (12) dudit boîtier, ladite couche de protection (4') englobant ledit boîtier et ledit bloc, ainsi que les connexions optique (6) et électrique dudit élément de réglage de température (18) et dudit circuit électronique de régulation (142) sur ladite longueur minimum (L).

8. Dispositif selon la revendication 7, **caractérisé en ce que** les fixations dudit composant (5) sur le substrat (15), du substrat sur lesdites protubérances (19) et du bloc (14) sur la seconde partie (12) du boîtier sont effectuées par collage (16, 141).

9. Dispositif selon la revendication 6, **caractérisé en ce que** ledit circuit de régulation de température est réalisé sous forme d'un bloc à interconnexions en trois dimensions (14) et **en ce que** ledit bloc (14) constitue la deuxième partie dudit boîtier et est fixé par collage (13) à ladite première partie (11) du boîtier pour délimiter ledit volume intérieur contenant le composant, ladite couche de protection (4') englobant ladite première partie (11), ledit bloc (14), ainsi que les connexions optiques (6) et électriques dudit élément de réglage de température (18) et dudit circuit électronique de régulation (142) sur ladite longueur minimum.

10. Dispositif selon l'une quelconque des revendications 1 à 4, **caractérisé en ce que** ledit composant est un composant optique ou optoélectronique (5) fixé sur une première face d'un substrat (15) plan, **en ce que** l'autre face dudit substrat porte en vis-à-vis du composant un élément de réglage de température (17, 17'), alimenté par un circuit électronique de régulation de température (14), **en ce que** ledit circuit de régulation de température est réalisé sous forme d'un bloc à interconnexions en trois dimensions (14), **en ce que** ledit bloc (14) constitue la deuxième partie dudit boîtier et est fixé par collage (13) à ladite première partie (21, 22) du boîtier pour délimiter ledit volume intérieur contenant le composant, ladite couche de protection (4') englobant ladite première partie (21, 22), ledit bloc (14), ainsi que les connexions optiques (6) et électriques dudit circuit électronique de régulation (142) sur ladite longueur minimum, et **en ce que** ledit bloc (14) comporte vers l'intérieur du boîtier des broches conductrices (144, 145) sensiblement perpendiculaires à la face intérieure (143) dudit bloc pour fixer mécaniquement ledit substrat et le composant et pour servir de connexion électrique dudit élément de réglage de température (17, 17') vers ledit circuit électronique de régulation.

11. Dispositif selon la revendication 10, **caractérisé en ce que** ledit élément de réglage de température est un élément de refroidissement à effet Peltier (17'), **en ce que** ladite première partie (22) du boîtier est en matériau bon conducteur thermique et **en ce qu'**entre la face chaude de l'élément de refroidissement et la face intérieure de ladite première partie du boîtier est interposée une couche (24) de liaison thermique pour assurer l'évacuation thermique.

12. Dispositif selon l'une quelconque des revendications 1 à 4 et 6 à 11, caractérisé en que les connexions et/ou liaisons sortant du boîtier sont dénudées à la sortie dudit boîtier sur un intervalle prédéterminé et en ce que ladite couche de protection minérale s'étend seulement jusque sur les parties dénudées des connexions et/ou liaisons, pour réduire ladite longueur minimum prédéterminée.

## Patentansprüche

1. Hermetische Verkapselungsvorrichtung eines Bauelementes, welches vor Spannungen aller Art geschützt werden soll, einer Art, welche ein durch mindestens zwei montierte Teile gebildetes Gehäuse beinhaltet, um ein Innenvolumen abzugrenzen, in welchem das Bauelement in einer trockenen Atmosphäre angeordnet ist, wobei die Vorrichtung **dadurch gekennzeichnet ist, dass** die beiden Teile (3, 3'; 11, 12; 11', 14; 21, 14; 22, 14) des Gehäuses durch Kleben aneinander oder in Vermittlung eines Substrates, welches das Bauelement trägt, montiert sind, dadurch, dass die Gesamtheit des Gehäuses durch eine mineralische Schutzschicht (4, 4') aus SiOx geschützt ist, wobei x im Wesentlichen zwischen 1,4 und 2 beträgt, welche sich ebenfalls über eine vorbestimmte Mindestlänge auf die Anschlüsse und/oder Verbindungen erstreckt, welche aus dem Gehäuse austreten, und dadurch, dass der Wert von x um einen ersten Wert kleiner als 2 in Kontakt mit dem Gehäuse variiert, welcher bestimmt wird, um eine optimale Haftung zu gewährleisten, bis zum Wert von 2 im Außenbereich, um eine maximale Luftdichtigkeit zu gewährleisten.

2. Vorrichtung nach Anspruch 1, **dadurch gekennzeichnet, dass** die vorbestimmte Mindestlänge (L) in der Größenordnung von einigen Millimetern liegt.

3. Vorrichtung nach einem der Ansprüche 1 oder 2, **dadurch gekennzeichnet, dass** die Dicke der Schutzschicht im Wesentlichen zwischen 0,1 und 5 Mikrometern beträgt.

4. Vorrichtung nach Anspruch 3, **dadurch gekennzeichnet, dass** die Dicke in der Größenordnung von 0,5 Mikrometer liegt.

5. Vorrichtung nach einem der Ansprüche 1 bis 4, **dadurch gekennzeichnet, dass** das Bauelement ein MEMS (1) ist, welches auf einem Substrat (2) montiert ist, welches Anschlussleiter (20) trägt, dadurch, dass das Gehäuse aus zwei Teilen (3,3') gebildet ist, welche einander auf beiden Seiten des Substrates zugewandt angeordnet und auf diesem verklebt (31) sind, wobei sich die Schutzschicht (4) über die beiden Teile und über die Leiter (20) und das Substrat über die Mindestlänge erstreckt.

6. Vorrichtung nach einem der Ansprüche 1 bis 4, **dadurch gekennzeichnet, dass** das Bauelement ein optisches oder optoelektrisches Bauelement (5) ist, welches auf einer ersten Seite eines ebenen Substrates (15) befestigt ist, dadurch, dass die andere Seite des Substrates gegenüber dem Bauteil ein Temperatureinstellelement (17) trägt, welches durch einen elektronischen Temperaturregelungskreis (14) gespeist wird, und dadurch, dass ein erster Teil (11) des Gehäuses mindestens einen inneren Vorsprung (19) beinhaltet, um dem Substrat (15) als Stütze zu dienen.

7. Vorrichtung nach Anspruch 6, **dadurch gekennzeichnet, dass** der Temperaturregelungskreis in Form eines Blocks mit Durchbindungen in drei Dimensionen (14) realisiert ist, welcher an dem anderen Teil (12) des Gehäuses befestigt ist, wobei die Schutzschicht (4') das Gehäuse und den Block sowie die optischen (6) und die elektrischen Anschlüsse des Temperatureinstellelementes (18) und des elektronischen Temperaturregelungskreises (142) über die Mindestlänge (L) einschließt.

8. Vorrichtung nach Anspruch 7, **dadurch gekennzeichnet, dass** die Befestigungen des Bauelementes (5) auf dem Substrat (15), des Substrates an den Vorsprüngen (19) und des Blocks (14) am zweiten Teil (12) des Gehäuses durch Verklebung (16, 141) erfolgen.

9. Vorrichtung nach Anspruch 6, **dadurch gekennzeichnet, dass** der Temperaturregelungskreis in Form eines Blocks mit Durchbindungen in drei Dimensionen (14) realisiert ist und dadurch, dass der Block (14) den zweiten Teil des Gehäuses bildet und durch Verklebung (13) am ersten Teil (11) des Gehäuses befestigt ist, um das Innenvolumen abzugrenzen, welches das Bauelement enthält, wobei die Schutzschicht (4') den ersten Teil (11), den Block (14) sowie die optischen (6) und die elektrischen Anschlüsse des Temperatureinstellelementes (18) und des elektronischen Temperaturregelungskreises (142) über die Mindestlänge (L) einschließt.

10. Vorrichtung nach einem der Ansprüche 1 bis 4, **dadurch gekennzeichnet, dass** das Bauelement ein optisches oder optoelektronisches Bauelement (5) ist, welches auf einer ersten Seite eines ebenen Substrates (15) befestigt ist, dadurch, dass die andere Seite des Substrates gegenüber dem Bauteil ein Temperatureinstellelement (17, 17') trägt, welches durch einen elektronischen Temperaturregelungskreis (14) gespeist wird, dadurch, dass der Temperaturregelungskreis in Form eines Blocks mit Durchbindungen in drei Dimensionen (14) realisiert ist, dadurch, dass der Block (14) den zweiten Teil des Gehäuses bildet und durch Verklebung (13) am ersten Teil (21, 22) des Gehäuses befestigt ist, um das Innenvolumen abzugrenzen, welches das Bauelement enthält, wobei die Schutzschicht (4') den ersten Teil (21, 22), den Block (14) sowie die optischen (6) und elektrischen Anschlüsse des elektronischen Temperaturregelungskreises (142) über die Mindestlänge einschließt, und dadurch, dass der Block (14) in Richtung des Gehäuseinneren leitende Pins (144, 145) beinhaltet, welche im Wesentlichen rechtwinklig zur Innenseite (143) des Blocks sind, um das Substrat und das Bauelement mechanisch zu befestigen und um als elektrischer Anschluss des Temperatureinstellelementes (17, 17') zum elektronischen Regelungskreis zu dienen.

11. Vorrichtung nach Anspruch 10, **dadurch gekennzeichnet, dass** das Temperatureinstellelement ein Kühlelement mit Peltier-Effekt (17') ist, dadurch, dass der erste Teil (22) des Gehäuses aus einem Material besteht, welches ein guter Wärmeleiter ist und dadurch, dass zwischen der warmen Seite des Kühlelementes und der Innenseite des ersten Teils des Gehäuses eine thermische Verbindungsschicht (24) zwischengeschaltet ist, um die Wärmeabführung zu gewährleisten.

12. Vorrichtung nach einem der Ansprüche 1 bis 4 und 6 bis 11, **dadurch gekennzeichnet, dass** die Anschlüsse und/oder Verbindungen, welche aus dem Gehäuse austreten, am Ausgang des Gehäuses über ein vorbestimmtes Intervall bloßgelegt sind und dadurch, dass die mineralische Schutzschicht sich nur bis auf die bloßgelegten Teile der Anschlüsse und/oder Verbindungen erstreckt, um die vorbestimmte Mindestlänge zu reduzieren.

## Claims

1. A device for the hermetic encapsulation of a component that has to be protected from any stress, of the type comprising a package formed from at least two portions joined together to define an internal volume in which the component is placed in a dry atmosphere, said device being **characterized in that** the two portions (3, 3'; 11, 12 ; 11', 14; 21, 14; 22, 14) of the package are joined together by adhesive bonding or via a substrate that supports said component, and **in that** the entire package is protected by a mineral protective layer (4, 4') of SiOx , where x is substantially comprised between 1.4 and 2, that also extends over a predetermined minimum length along the connections and/or links leaving the package, and **in that** the value of x varies from a first value of less than 2 in contact with the package, determined to ensure optimum adhesion, up to the value of 2 on the outside, in order to ensure maximum hermeticity.

2. The device as claimed in claim 1, **characterized in that** said predetermined minimum length (L) is of the order of a few millimeters.

3. The device as claimed in either of claims 1 or 2, **characterized in that** the thickness of said protective layer is substantially between 0.1 and 5 microns.

4. The device as claimed in claim 3, **characterized in that** said thickness is around 0.5 microns.

5. The device as claimed in any one of claims 1 to 4, **characterized in that** said component is a MEMS (1), mounted on a substrate (2) carrying connection conductors (20), **in that** said package is formed from two portions (3, 3') placed facing each other on either side of the substrate and adhesively bonded (31) to the latter, said protective layer (4) extending over said two portions and along said conductors (20) and the substrate over said minimum length.

6. The device as claimed in any one of claims 1 to 4, **characterized in that** said component is an optical or electrooptic component (5) fastened to a first face of a plane substrate (15), **in that** the other face of said substrate bears, facing the component, a temperature-regulating element (17), supplied by an electronic temperature-regulating circuit (14), and **in that** a first portion (11) of said package includes at least one internal protuberance (19) acting as support for said substrate (15).

7. The device as claimed in claim 6, **characterized in that** said temperature-regulating circuit is produced in the form of a three-dimensional interconnection block (14) that is fastened to the other portion (12) of said package, said protective layer (4') encapsulating said package and said block, and also the optical (6) and electrical connections for said temperature-regulating element (18) and for said electronic regulating circuit (142) over said minimum length (L).

8. The device as claimed in claim 7, **characterized in that** the fastening of said component (5) to the substrate (15), the fastening of the substrate to said protuberances (19) and the fastening of the block (14) to the second portion (12) of the package are effected by adhesive bonding (16, 141).

9. The device as claimed in claim 6, **characterized in that** said temperature-regulating circuit is produced in the form of a three-dimensional interconnection block (14) and **in that** said block (14) constitutes the second portion of said package and is fastened by adhesive bonding (13) to said first portion (11) of the package in order to define said internal volume containing the component, said protective layer (4') encapsulating said first portion (11), said block (14) and the optical (6) and electrical connections for said temperature-regulating element (18) and for said electronic regulating circuit (142) over said minimum length.

10. The device as claimed in any one of claims 1 to 4, **characterized in that** said component is an optical or optoelectronic component (5) fastened to a first face of a plane substrate (15), **in that** the other face of said substrate carries, facing the component, a temperature-regulating element (17, 17'), which is supplied by an electronic temperature-regulating circuit (14), **in that** said temperature-regulating circuit is produced in the form of a three-dimensional interconnection block (14), **in that** said block (14) constitutes the second portion of said package and is fastened by adhesive bonding (13) to said first portion (21, 22) of the package in order to define said internal volume containing the component, said protective layer (4') encapsulating said first portion (21, 22), said block (14) and the optical (6) and electrical connections for said electronic regulating circuit (142) over said minimum length, and **in that** said block (14) includes, toward the inside of the package, conducting pins (144, 145) approximately perpendicular to the internal face (143) of said block in order to mechanically fasten said substrate and the component and to serve for electrically connecting said temperature-regulating element (17, 17') to said electronic regulating circuit.

11. The device as claimed in claim 10, **characterized in that** said temperature-regulating element is a Peltier-effect cooling element (17'), **in that** said first portion (22) of the package is made of a material that is a good thermal conductor and **in that**, between the warm face of the cooling element and the internal face of said first portion of the package, a thermal connecting layer (24) is interposed in order to dissipate heat.

12. The device as claimed in any one of claims 1 to 4 and 6 to 11, **characterized in that** the connections and/or links leaving the package are stripped at the outlet of said package over a predetermined distance and **in that** said mineral protective layer extends only up to the stripped portions of the connections and/or links, in order to reduce said predetermined minimum length.
